# EUROPEAN PATENT APPLICATION

(11) **EP 2 432 010 A1**
(43) Date of publication of application: **21.03.2012**
(21) Application number: 11007439.0
(22) Date of filing: 13.09.2011
(51) Int. Cl.: H01L 21/683, H01L 21/78

(54) **Manufacturing method of semiconductor device**

(30) Priority: 15.09.2010 JP 2010206900
(71) Applicant: Asahi Glass Company, Limited, Chiyoda-ku Tokyo 100-8405 (JP)
(72) Inventor: Higuchi, Toshihiko, Tokyo 100-8405 (JP)
(74) Representative: Müller-Boré & Partner Patentanwälte

(57) **Abstract**

The present invention relates to a method for manufacturing a semiconductor device, containing: a first step of producing a first component part of a semiconductor device on a first surface of a semiconductor wafer; a second step of laminating a support plate to the first surface of the semiconductor wafer, on which the first component part has been produced, through only a silicone resin layer therebetween; a third step of grinding a second surface opposing the first surface of the semiconductor wafer, in the state of the support plate being laminated, and then producing a second component part of the semiconductor device on the ground surface; and a fourth step of peeling off the silicone resin layer from the semiconductor wafer on which the first component part and the second component part have been produced, thereby removing the silicone resin layer and the support plate, and cutting the semiconductor wafer into a chip.

## Description

The present invention relates to a manufacturing method of a semiconductor device.

In the process of producing a semiconductor device, after forming an electronic circuit or the like on the surface of a semiconductor wafer (hereinafter, sometimes simply referred to as a "wafer"), the back surface grinding (so-called back grinding) of the wafer is sometimes performed in order to reduce the thickness of the wafer. In this case, for the purpose of, for example, protecting the circuit surface of the wafer or fixing the wafer, a support plate is usually laminated to the circuit surface of the wafer through a double-coated adhesive sheet (see, for example, Patent Document 1).

When the support plate is laminated to the circuit surface of the wafer, the wafer reduced in the thickness after back surface grinding of the wafer can be reinforced, and a back surface electrode or the like can be also formed on the ground surface of the wafer. Thereafter, the double-coated adhesive sheet is separated from the circuit surface of the wafer, whereby the double-coated adhesive sheet and the support plate are removed. Furthermore, the wafer is cut to produce a chip.

By the way, chip lamination technology utilizing a penetrating electrode (for example, silicon penetrating electrode) provided so as to penetrate through the wafer has been recently developed. According to this chip lamination technology, electronic circuits of a plurality of chips are electrically connected using a penetrating electrode in place of conventional wiring, so that the chip integration density and the operation speed can be enhanced.

In the case of using this chip lamination technology, back surface grinding of a wafer is often performed so as to reduce the total thickness of a plurality of chips. Therefore, occasion to utilize a support plate and a double-coated adhesive sheet is increasing.

Patent Document 1: JP-A-2004-26950

However, it is difficult to apply the conventional double-coated adhesive sheet to the semiconductor device production process including processing at high temperatures, because the resin constituting the base material film has a low heat resistance.

The present invention has been made by taking these problems into consideration, and an object of the present invention is to provide a manufacturing method of a semiconductor device, which is suitable for processing at high temperatures.

In order to solve the above problems, the present invention provides:
a method for manufacturing a semiconductor device, comprising:
   a first step of producing a first component part of a semiconductor device on a first surface of a semiconductor wafer;
   a second step of laminating a support plate to the first surface of the semiconductor wafer, on which the first component part has been produced, through only a silicone resin layer;
   a third step of grinding a second surface opposing the first surface of the semiconductor wafer, in the state of the support plate being laminated, and then producing a second component part of the semiconductor device on the ground surface; and
   a fourth step of peeling off the silicone resin layer from the semiconductor wafer on which the first component part and the second component part have been produced, thereby removing the silicone resin layer and the support plate, and cutting the semiconductor wafer into a chip.

It is preferred that the second component part contains a penetrating electrode penetrating from the ground surface to the first surface of the semiconductor wafer.

It is preferred that the silicone resin layer is formed of a cured product of a silicone for release paper.

It is preferred that the cured product of a silicone for release paper is a cross-linking-reaction product of a linear polyorganosiloxane having a vinyl group at both terminals and/or in the side chain and a methylhydrogenpolysiloxane having a hydrosilyl group within the molecule.

It is preferred that the molar ratio (hydrosilyl group/vinyl group) between the hydrosilyl group contained in the methylhydrogenpolysiloxane and the vinyl group contained in the linear polyorganosiloxane is from 1.3/1 to 0.7/1.

It is preferred that the absolute value of the difference in the average linear expansion coefficient between the support plate and the semiconductor wafer is 35×10⁻⁷/°C or less.

It is preferred that, in the second step, the support plate is pressure-contacted with the first surface of the semiconductor wafer, on which the first component part has been produced, through the silicone resin layer under a reduced pressure atmosphere.

It is preferred that, in the second step, after fixing the silicone resin layer to the support plate, the silicone resin layer is laminated to the first surface of the semiconductor wafer, on which the first component part has been produced.

It is preferred that the silicone resin layer is formed and fixed by coating and curing a silicone for release paper on the support plate.

It is preferred that the content of a nonreactive silicone in the silicone for release paper is 5 mass% or less.

It is preferred that the silicone for release paper is coated by using a die-coating method, a spin-coating method or a screen-printing method.

It is preferred that the silicone for release paper is cured at a temperature of 50 to 250°C.

According to the present invention, a manufacturing method of a semiconductor device, which is suitable for processing at high temperature, can be provided.

FIG. 1 is an explanatory view (1) of the manufacturing method of a semiconductor device according to one embodiment of the present invention.
FIG. 2 is an explanatory view (2) of the manufacturing method of a semiconductor device according to one embodiment of the present invention.
FIG. 3 is an explanatory view (3) of the manufacturing method of a semiconductor device according to one embodiment of the present invention.
FIG. 4 is an explanatory view (4) of the manufacturing method of a semiconductor device according to one embodiment of the present invention.
FIG. 5 is an explanatory view (5) of the manufacturing method of a semiconductor device according to one embodiment of the present invention.
FIG. 6 is an explanatory view of a modification example of FIG. 1.
FIG. 7 is an explanatory view of a modification example of FIG. 4.
FIG. 8 is an explanatory view (1) of the second step.
FIG. 9 is an explanatory view (2) of the second step.
FIG. 10 is an explanatory view (3) of the second step.

- 10: Semiconductor wafer
- 11: First surface
- 12: Second surface
- 13: Ground surface
- 20: Semiconductor device
- 21: First component part
- 22: Second component part
- 23: Penetrating electrode
- 24: Penetrating electrode
- 30: Silicone resin layer
- 32: Silicone resin composition
- 40: Support plate

The mode for carrying out the present invention is described below by referring to the drawings.

Here, the present invention is not limited to the embodiments described below, and various modifications and substitutions may be made in the embodiments described below without departing from the scope of the invention.

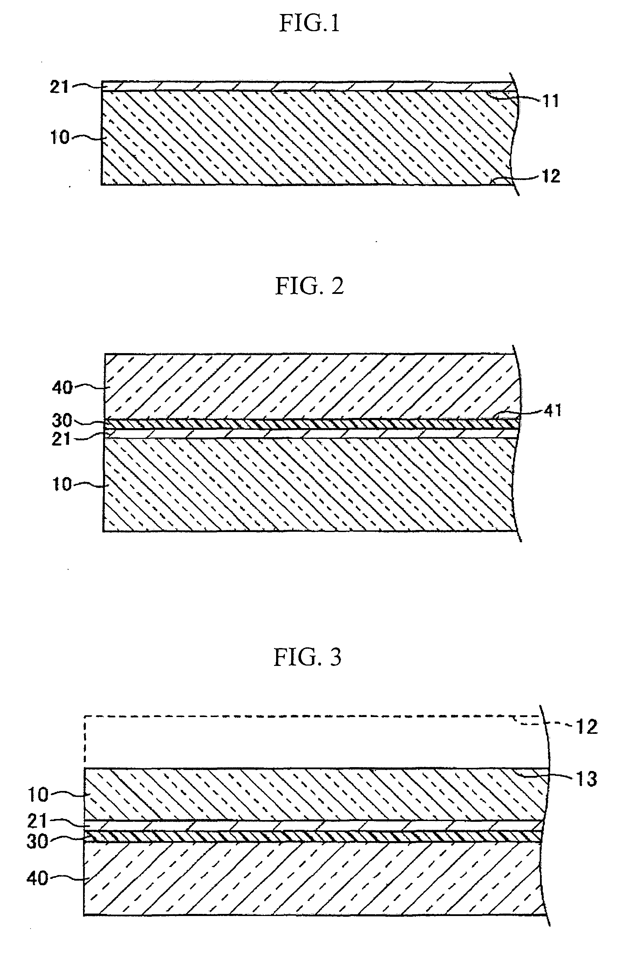

FIGs. 1 to 5 are explanatory views of the manufacturing method of a semiconductor device according to one embodiment of the present invention. FIGs. 1 to 5 are a side surface cross-sectional view.

### (First Step)

In the first step, as shown in FIG. 1, a first component part 21 of a semiconductor device 20 is produced on a first surface 11 of a semiconductor wafer 10 (hereinafter, sometimes simply referred to as a "wafer 10").

The wafer 10 is not particularly limited but may be, for example, a silicon (Si) wafer, a silicon carbide (SiC) wafer, a sapphire wafer or a compound semiconductor wafer. Examples of the compound semiconductor wafer include a gallium nitride (GaN) wafer, a gallium arsenic (GaAs) wafer, and an indium phosphide (InP) wafer.

The semiconductor device 20 is not particularly limited but may be, for example, IC (Integrated Circuit), LSI (Large Scale Integration) or IGBT (Insulated Gate Bipolar Transistor). The semiconductor device 20 contains a first component part 21 produced on the first surface 11 side of the wafer 10 and a second component part 22 produced on the second surface 12 side opposing the first surface 11 of the wafer 10.

The first component part 21 may have a general configuration and, for example, may contain a transistor, wiring, a first surface electrode and the like. The production method of the first component part 21 may be a general method used for the manufacture of a semiconductor device 20, and examples of the method include a photolithography method, an etching method, an ion plantation method, a CVD (Chemical Vapor Deposition) method or the like.

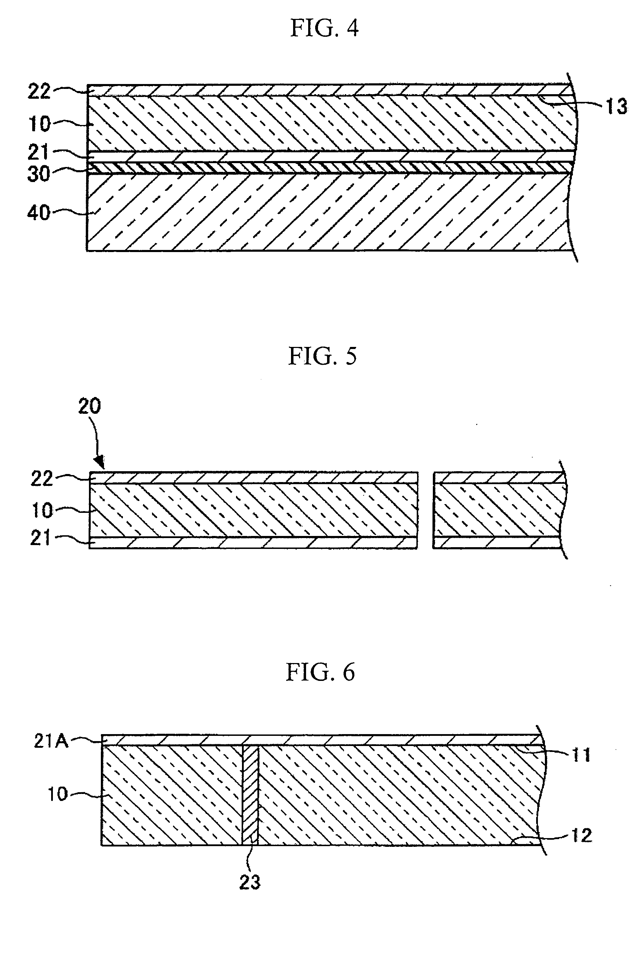

FIG. 6 is an explanatory view of a modification example of FIG. 1. The first component part 21A shown in FIG. 6 contains a penetrating electrode 23 provided to penetrate from the first surface 11 to the second surface 12 of the wafer 10, in addition to the above-described transistor and the like. The penetrating electrode 23 is produced, for example, by forming a through hole (Via) in the wafer 10, forming an insulating film on the inner wall of the through hole, and forming an electric conductor on the insulating film. The through hole is formed by using an RIE (Reactive Ion Etching) method or the like. The insulating film is formed by using a plasma CVD method or the like. The electric conductor is formed, for example, by using metal plating such as copper plating or by a method of depositing a polysilicon film by CVD.

### (Second Step)

In the second step, for the purpose of, for example, protecting the first component part 21 and fixing the wafer 10, as shown in FIG. 2, a support plate 40 is laminated to the surface of the semiconductor wafer 10 on the side where the first component part 21 is produced, through only a silicone resin layer 30 therebetween. That is, a support plate 40 is laminated to the surface of the first component part 21 through only a silicone resin layer 30 therebetween.

The silicone resin layer 30 prevents positional slippage of the wafer 10 having the first component part 21 produced thereon until a peeling operation is performed in the later-described fourth step, and at the same time, the silicone resin layer 30 is easily separated from the wafer 10 in a peeling operation while keeping the wafer 10 from being damaged in the peeling operation.

The silicone resin layer 30 is preferably laminated to the wafer 10 having the first component part 21 produced thereon, not by a pressure-sensitive adhesive force of a general pressure-sensitive adhesive but by a force attributable to van der Waals' force between solid molecules. Such resin layer can be easily peeled off. In the following, this easily peelable property is referred to as releasability.

Incidentally, in the case where bonding force to the wafer 10 having the first component part 21 produced thereon needs to be increased due to the kind of the later step, the silicone resin layer 30 may be adhered to the wafer 10 by a pressure-sensitive adhesive force.

The silicone resin layer 30 is formed such that the bonding force to the support plate 40 becomes relatively higher than the bonding force to the wafer 10 having the first component part 21 produced thereon. Thanks to this configuration, unintended separation between the silicone resin layer 30 and the support plate 40 can be prevented at the time of performing a peeling operation in the later-described fourth step.

The silicone resin layer 30 is excellent in heat resistance and is excellent in that, for example, when it is treated in air at about 300°C for 1 hour in a state of being sandwiched between the wafer 10 and the support plate 40, its releasability is scarcely changed.

The silicone resin layer 30 may have a single-layer structure or a multilayer structure. In the case of a multilayer structure, the silicone resin layer 30 may contain cured products formed from a plurality of kinds of silicone resin compositions different from each other.

The silicone resin layer 30 preferably has a low silicone migration property that is a property of allowing less transfer of the component in the silicone resin layer 30 to the wafer 10 having the first component part 21 produced thereon.

The thickness of the silicone resin layer 30 is not particularly limited but is preferably from 1 to 100 µm. When the thickness of the silicone resin layer 30 is in this range, the silicone resin layer 30 can be adequately adhered to the wafer 10 having the first component part 21 produced thereon and even when an air bubble or an extraneous substance such as dust is present at laminating, the thickness of the extraneous substance can be sufficiently absorbed. On the other hand, if the thickness of the silicone resin layer 30 is too large, the time and material required for the formation are increased and this is unprofitable. The thickness is more preferably from 5 to 20 µm.

The silicone resin layer 30 preferably has a surface energy of 16 to 21 mJ/m² before laminating to the wafer 10 having the first component part 21 produced thereon. When the surface energy is in this range, an air bubble entrained at the time of laminating can be easily removed. Also, when the surface energy is in the range above, in the fourth step, the silicone resin layer 20 can be easily separated from the wafer 10 having the first component part 21 produced thereon. In this case, the surface energy of silicone resin layer is obtained as follows. First, with using some kinds of liquid of which surface tensions are known, contact angle (θ) of each of these liquids to the silicone resin layer is measured. The relationship of the surface tensions and contact angles of these liquids with regard to the silicone resin layer is plotted and the surface energy is calculated from the surface tension obtained by approximation of cosθ' by 1 in the linear approximation equation.

The surface size of the silicone resin layer 30 is not particularly limited but may be the same as the surface size of the support plate 40.

The support plate 40 reinforces the wafer 10 by supporting it through the silicone resin layer 30, and prevents deformation, scratching, breakage or the like of the wafer 10 in the later step.

The support plate 40 is formed of a material having higher heat resistance than the silicone resin layer 30. Examples of the support plate 40 include a glass plate, a ceramic plate, an acrylic board, a semiconductor plate or a metal plate. Among these, a glass plate is preferred. The material of the glass plate is not particularly limited but may be, for example, soda-lime glass or alkali-free glass. Above all, an alkali-free glass having a small thermal expansion difference from the wafer 10 is preferred.

The absolute value of the difference in the average linear expansion coefficient between the support plate 40 and the wafer 10 may be appropriately set according to the size or the like of the first surface 11 of the wafer 10 but is preferably, for example, 35×10⁻⁷/°C or less. The average linear expansion coefficient as used herein indicates an average linear expansion coefficient at a temperature range of 50 to 300°C (JIS R 3102-1995).

When the absolute value of the difference in the average linear expansion coefficient between the support plate 40 and the wafer 10 is set to 35×10⁻⁷/°C or less, warpage due to heat treatment in the later step (for example, third step) can be sufficiently reduced. The absolute value of the difference is more preferably 25×10⁻⁷/°C or less, and still more preferably 15×10⁻⁷/°C or less. As long as the absolute value of the difference is in the range above, the average linear expansion coefficient of the support plate 40 may be larger or smaller than that of the wafer 10.

The thickness of the support plate 40 is appropriately set according to the material of the support plate 40 or the like but may be, for example, from 0.01 to less than 1.0 mm. By setting the thickness to 0.01 mm or more, the wafer 10 can be sufficiently reinforced. If the thickness is 1.0 mm or more, the plate becomes large-sized and this is not preferred.

The surface 41 of the support plate 40 on the side where the silicone resin layer 30 is to be formed may be a polished surface having been subjected to a treatment by mechanical polishing or chemical polishing, or may be an unpolished surface not having been subjected to a polishing treatment. In view of productivity and cost, the surface is preferably an unpolished surface.

The size of the surface 41 of the support plate 40 is preferably the same as or greater than the size of the first surface of the wafer 10, from the standpoint of protecting the first component part 21 produced on the first surface 11 of the wafer 10.
Details of the second step are described later.

### (Third Step)

In the third step, as shown in FIGs. 3 and 4, the semiconductor wafer 10 still with the support 40 laminated thereon is turned over and the second surface 12 of the semiconductor wafer 10 is ground. After ground, the second component part 22 of the semiconductor device 20 is produced on the ground surface 13. For cleaning the ground surface 13, the ground surface 13 is preferably washed and dried before producing the second component part 22 of the semiconductor device 20.

The second component part 22 may have a general configuration and, for example, may contain a second surface electrode. Also, the second component part 22 may contain a transistor, wiring and the like, in addition to the second surface electrode. The production method of the second component part 22 is the same as the production method of the first component part 21.

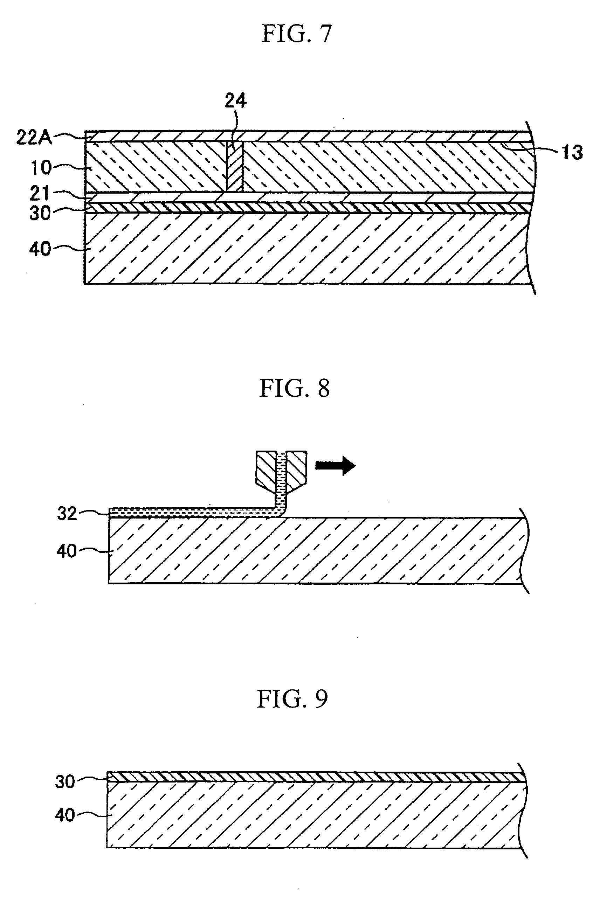

FIG. 7 is an explanatory view of a modification example of FIG. 4. The second component part 22A shown in FIG. 7 contains a penetrating electrode 24 provided to penetrate from the ground surface 13 to the first surface 11 of the wafer 10, in addition to the above-described second surface electrode. The penetrating electrode 24 shown in FIG. 7 is formed in place of the penetrating electrode 23 shown in FIG. 6 and is formed in the same manner as the penetrating electrode 23 shown in FIG. 6.

As shown in FIG. 7, in the case of producing a penetrating electrode 24 from the ground surface 13 of the wafer 10, the penetrating electrode 24 can be easily produced, because the thickness of the wafer 10 is already reduced. On the other hand, as shown in FIG. 6, in the case of producing a penetrating electrode 23 from the first surface 11 of the wafer 10, the silicone resin layer 30 and the like are not used when producing the penetrating electrode 23 and therefore, processing at a higher temperature can be conducted.

### (Fourth Step)

In the fourth step, as shown in FIG. 5, the silicone resin layer 30 is peeled off from the semiconductor wafer 10 having the first component part 21 and the second component part 22 produced thereon, whereby the silicone resin layer 30 and the support plate 40 are removed. That is, the silicone resin layer 30 and the support plate 40 are removed by peeling off the silicone resin layer 30 from the surface of the first component part 21.

The peeling method may be a method of inserting a razor, a compressed air, or a mixture of a compressed air and a liquid, into a boundary between the first component part 21 and the silicone resin layer 30 and performing incipient separation. By performing incipient separation, the subsequent separation can be easily performed. After the separation, when a defect such as scratch is not present in the silicone resin layer 30, the reinforcing plate containing the silicone resin layer 30 and the support plate 40 may be reutilized as it is. In the case of spending a long time before reutilization, a protective sheet is preferably laminated on the surface of the silicone resin layer 30.

In addition, in the fourth step, as shown in FIG. 5, the semiconductor wafer 10 having the first component part 21 and the second component part 22 produced thereon is cut into a chip form. Incidentally, the cutting step of cutting the semiconductor wafer 10 into a chip form and the separation step of peeling off the silicone resin layer 30 are not limited in their order, and either step may be done first.

In the case of performing the cutting step after the separation step, the wafer 10 is preferably cut into a chip form in the state of a general dicing tape being laminated on the ground surface 13 of the wafer 10. On the other hand, in the case of performing the cutting step before the separation step, the reinforcing plate containing the silicone resin layer 30 and the support plate 40 takes the role of a dicing tape and therefore, a dicing tape can be dispensed with.

In this way, a semiconductor device is manufactured.

In this embodiment, in the second step, when laminating the support plate 40 to the wafer 10 having the first component part 21 produced thereon, only a silicone resin layer 30 is used and a conventional resin-made tape base material is not used. This is because when the resin-made tape base material has unevenness in the thickness, unevenness is produced in the thickness of the wafer at the time of grinding the second surface and the surface roughness Ra (JIS B 0601-2001) of the ground surface 13 of the wafer 10 after second surface grinding becomes large. Therefore, according to this embodiment, the surface roughness Ra of the ground surface 13 of the wafer 10 after second surface grinding can be made small as compared to conventional one.

Also, as described above, the silicone resin layer 30 is excellent in heat resistance and, for example, when it is treated in air at about 300°C for 1 hour in a state of being sandwiched between the wafer 10 and the support plate 40, its releasability is scarcely changed. Therefore, even when a treatment is performed at high temperature in the third step, positional slippage of the wafer 10 can be prevented until a peeling operation is performed in the fourth step and at the same time, the silicone resin layer 30 can be easily separated from the wafer 10 by the peeling operation in the fourth step, so that the wafer 10 and the like can be prevented from breakage. This effect is remarkable when the second component part 22 contains a penetrating electrode 24. Because, in this case, in the third step, an insulating film is formed at a temperature of 300 to 400°C on the inner wall surface of a through hole penetrating through the wafer 10.

### (Details of Second Step)

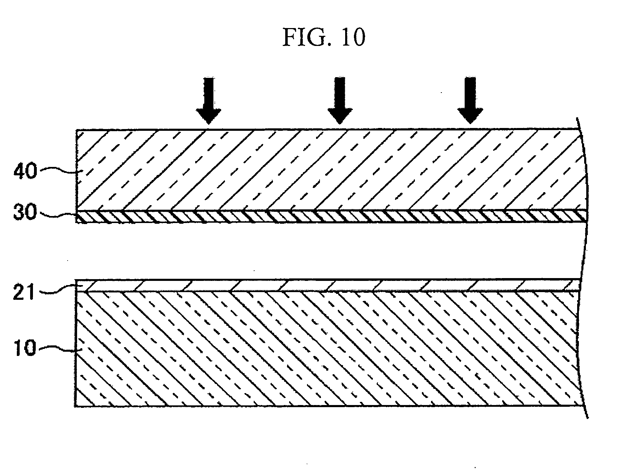

For example, in the second step, as shown in FIG. 10, a silicone resin layer 30 is fixed to a support plate 40 and thereafter, the silicone resin layer 30 is laminated to the surface of the semiconductor wafer 10 on the side where the first component part 21 has been produced. That is, after fixing a silicone resin layer 30 to a support plate 40, the silicone resin layer 30 is laminated to the surface of the first component part 21.

In this case, the silicone resin layer 30 may be formed and fixed, for example, by coating a silicone resin composition 32 on a support plate 40 as shown in FIG. 8, and curing the composition as shown in FIG. 9. At this time, the silicone resin composition 32 is allowed to interact with the support plate 40, so that the bonding force between the silicone resin layer 30 and the support plate 40 can be increased.

Incidentally, in the case where the silicone resin composition 32 contains a volatile component such as solvent, the volatile component is preferably removed by heating or the like before curing.

The method for coating the silicone resin composition 32 is not particularly limited, but examples thereof include a spray-coating method, a die-coating method, a spin-coating method, a dip-coating method, a roll-coating method, a bar-coating method, a screen-printing method, and a gravure-coating method. Such a coating method can be appropriately selected according to the kind of the silicone resin composition 32. For example, in the case where the silicone resin composition 32 contains silicone for release paper, a die-coating method, a spin-coating method or a screen-printing method is preferred.

The coated amount of the silicone resin composition 32 is appropriately set according to the kind of the silicone resin composition 32. For example, in the case where the silicone resin composition 32 is a solventless silicone for release paper, the coated amount is preferably from 1 g/m² to 100 g/m², and more preferably from 5 g/m² to 20 g/m².

The conditions in the curing of the silicone resin composition 32 are appropriately selected according to the kind or the like of the silicone resin composition 32. For example, in the case where the silicone resin composition 32 contains a silicone for release paper, the heating temperature is preferably from 50 to 250°C, more preferably from 100 to 200°C, and the heating time is preferably from 5 to 60 minutes, more preferably from 10 to 30 minutes.

When the silicone for release paper is cured under the above-described curing conditions, the content of the unreacted silicone component contained in the silicone resin layer 30 can be sufficiently reduced. As a result, a silicone resin layer 30 excellent in low silicone migration property can be formed on the support plate 40. Also, thanks to the effect above, it can prevent the interaction of the unreacted silicone component contained in the silicone resin layer 30 with the first component part 21 at a heat treatment in the later step, and therefore, the bonding force between the silicone resin layer 30 and the first component part 21 can be kept from becoming excessively high.

If the heating time is too long or the heating temperature is too high compared with the above-described curing conditions, oxidative decomposition of the silicone resin occurs at the same time and a low molecular weight silicone component is produced, giving rise to high silicone migration property.

The method for laminating the silicone resin layer 30 to the surface of the first component part 21 is not particularly limited but includes, for example, a method of pressure-contacting them in an air-pressure atmosphere or a reduced pressure atmosphere. Above all, a method of pressure-contacting them in a reduced pressure atmosphere is preferred, because entrainment of an air bubble is suppressed. The system for pressure-contacting includes, for example, a roll system and a press system.

The step of laminating the silicone resin layer 30 to the surface of the first component part 21 is preferably performed in an environment with high cleanliness, because attachment of an extraneous substance such as dust gives rise to breakage, distortion or the like of the semiconductor device 20.

The second step is not limited to the above-described step. For example, in the case where the silicone resin layer 30 previously formed like a film shape has high adhesiveness to the support plate 40 and low adhesiveness to the first component part 21, the silicone resin layer 30 previously formed like a film shape may be sandwiched between the support plate 40 and the first component part 21 and they may be pressure-contacted in an air-pressure atmosphere or a reduced pressure atmosphere. The surface 41 of the support plate 40 before stacking with the silicone resin layer 30 may be treated to improve the adhesiveness to the silicone resin layer 30.

As another method, in the case where the adhesive property by curing of the silicone resin composition 32 is low with respect to the first component part 21 and high with respect to the support plate 40, the silicone resin composition 32 may be cured between the support plate 40 and the first component part 21 to form the silicone resin layer 30. The surface 41 of the support plate 40 before stacking with the silicone resin composition 32 may be treated to improve the adhesive property at the curing of the silicone resin composition 32.

### (Silicone Resin Composition)

The silicone resin composition 32 preferably contains a silicone for release paper. Among silicones, the silicone for release paper contains, as a main ingredient, a silicone containing, in the molecule thereof, a linear dimethylpolysiloxane particularly excellent in releasability. The silicone for release paper contains the above-described main ingredient and a cross-linking agent and is cured by a catalyst, a photopolymerization initiator or the like. The cured product of the silicone for release paper becomes a silicone resin layer 30 having excellent releasability and appropriate flexibility.

The content of nonreactive silicone in the silicone for release paper is preferably 5 mass% or less. The nonreactive silicone as used herein means a silicone incapable of reacting with the main ingredient or the cross-linking agent. By setting the content to 5 mass% or less, a silicone resin layer 30 excellent in low silicone migration property can be formed.

For the purpose of increasing the releasability of the silicone resin layer 30, the content of the nonreactive silicone in the silicone for release paper may be set to exceed 5 mass%. In this case, there may be used as the nonreactive silicone a very high molecular weight linear dimethylpolysiloxane, or a silicone having a relatively low molecular weight, in which a phenyl group or a higher alkyl group is introduced to reduce the compatibility with the cured film.

The silicone for release paper includes, in terms of its form, a solution type, an emulsion type and a solventless type, and any type of silicone can be used. However, from the standpoint of productivity, safety and environmental characteristics, a solventless type is preferred. In the case of using a solventless type, an air bubble is less likely to remain in the silicone resin layer 30.

The silicone for release paper is classified into a condensation reaction-type silicone, an addition reaction-type silicone, an ultraviolet curable silicone, and an electron beam curable silicone, according to curing mechanism. A silicone of any reaction mechanism can be used. Among these, the addition reaction-type silicone facilitates the curing reaction, gives a cured product with good releasability, and ensures excellent heat resistance of the cured product.

The addition reaction-type silicone contains: a main ingredient A composed of a linear polyorganosiloxane having a vinyl group at both terminals and/or in the side chain; and a cross-linking agent B composed of a methylhydrogenpolysiloxane having a hydrosilyl group within the molecule, and this silicone is cured under heating in the presence of a platinum-based catalyst and becomes a cross-linking-reaction product. In this case, each of the linear polyorganosiloxane having a vinyl group at both terminals and/or in the side chain and the methylhydrogenpolysiloxane having a hydrosilyl group within the molecule have weight average molecular weight, Mw, of preferably from 1,000 to 5,000,000. Mws are more preferably from 2,000 to 3,000,000, and further preferably from 3,000 to 1,000,000. When Mws of the linear polyorganosiloxane having a vinyl group at both terminals and/or in the side chain and the methylhydrogenpolysiloxane having a hydrosilyl group within the molecule is in the above range, the addition reaction-type silicone can be suppressed from volatilization of low molecular weight components at curing treatment under heating and can maintain excellent workability without getting too high viscosity.

This cross-linking-reaction product has very high heat resistance by virtue of highly proceeded three-dimensional cross-linking and also has surface characteristics of low surface tension and hardly-sticking property to other substances. Thanks to these characteristics, a silicone resin layer 30 excellent in releasability can be obtained.

On the other hand, this cross-linking-reaction product has appropriate elasticity and exhibits great resistance to shear force (Shearing Force) in the in-plane direction. Accordingly, this product can continuously and sliplessly hold the wafer 10 having the first component part 21 produced thereon.

The main ingredient A may be, for example, a compound represented by the following formulae ((1) or (2)).

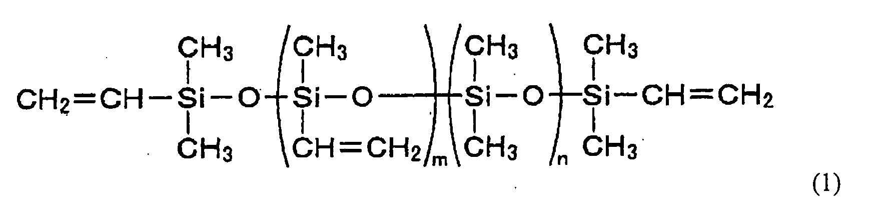

In formula (1), each of m and n represents an integer of 0 or more. When m is 0, this compound becomes a linear polyorganosiloxane having vinyl groups only at both terminals. When m is an integer of 1 or more, this compound becomes a linear polyorganosiloxane having vinyl groups at both terminals and in the side chain.

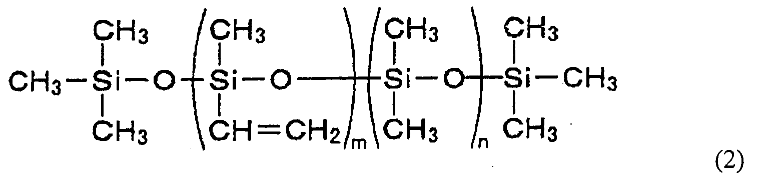

In formula (2), m represents an integer of 2 or more, and n represents an integer of 0 or more. This compound is a linear polyorganosiloxane having vinyl groups only in the side chain.

The cross-linking agent B may be, for example, a compound represented by the following formula (3).

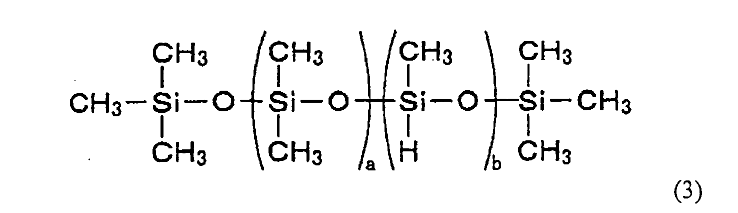

In formula (3), a represents an integer of 0 or more, and b represents an integer of 1 or more. Incidentally, a part of methyl groups at the terminals of methylhydrogenpolysiloxane may be a hydrogen atom or a hydroxyl group.

The mixing ratio of the main ingredient A and the cross-linking agent B is preferably adjusted such that the molar ratio between the hydrosilyl group contained in the cross-linking agent B and the vinyl group contained in the main ingredient A (hydrosilyl group/vinyl group) becomes from 1.3/1 to 0.7/1, and more preferably from 1.2/1 to 0.8/1.

If the molar ratio (hydrosilyl group/vinyl group) exceeds 1.3/1, the content of the unreacted cross-linking agent B contained in the silicone resin layer 30 becomes too large. In turn, the bonding force between the silicone resin layer 30 and the wafer 10 having the first component part 21 produced thereon is likely to be increased by a heat treatment in the later step (for example, third step), and insufficient releasability may result. On the other hand, if the molar ratio (hydrosilyl group/vinyl group) is less than 0.7/1, the cross-link density of the cured product is reduced and there may arise a problem in the chemical resistance and the like.

The main ingredient A and the cross-linking agent B are, as described above, cured under heating in the presence of a platinum-based catalyst and become a cross-linking-reaction product. As for the platinum-based catalyst, a known catalyst may be used. Specific examples thereof include: a chloroplatinic acid such as platinous chloride and platinic chloride; an alcohol or aldehyde compound of chloroplatinic acid; and a chained salt of chloroplatinic acid with various olefins. The platinum-based catalyst is preferably used in an amount of 0.1 to 20 parts by mass, and more preferably from 1 to 10 parts by mass, per 100 parts by mass in total of the main ingredient A and the cross-linking agent B.

The combination of the main ingredient A and the cross-linking agent B is not particularly limited, but examples thereof include KNS-320A, KS-847 (both produced by Shin-Etsu Chemical Co., Ltd.), TPR6700 (produced by Momentive Performance Materials Inc.), a combination of vinyl silicone "8500" (produced by Arakawa Chemical Industries, Ltd.) with methylhydrogenpolysiloxane "12031" (produced by Arakawa Chemical Industries, Ltd.), a combination of vinyl silicone "11364" (produced by Arakawa Chemical Industries, Ltd.) with methylhydrogenpolysiloxane "12031", and a combination of vinyl silicone "11365" with methylhydrogenpolysiloxane "12031". Incidentally, each KNS-320A, KS-847 and TPR6700 is a silicone already containing the main ingredient A and the cross-linking agent B.

### EXAMPLES

The present invention is described in greater detail below by referring to Example or the like, but the present invention is not limited to this Example.

### (Example)

In Example, an alkali-free glass plate (AN100, produced by Asahi Glass Company, Ltd.) having a diameter of 350 mm, a plate thickness of 0.6 mm and a linear expansion coefficient of 38×10⁻⁷/°C, with the surface being cleaned by pure water washing and UV washing, was prepared as a support plate.

Subsequently, as a silicone resin composition, a silicone for release paper was prepared. As the silicone for release paper, a solventless addition reaction-type silicone obtained by blending a linear polyorganosiloxane having a vinyl group at both terminals (main ingredient, "8500", produced by Arakawa Chemical Industries, Ltd.), a methylhydrogenpolysiloxane having a hydrosilyl group within the molecule (cross-linking agent, "12031 ", produced by Arakawa Chemical Industries, Ltd.), and a platinum-based catalyst ("CAT12070", produced by Arakawa Chemical Industries, Ltd.) was prepared.

Here, the mixing ratio of the main ingredient and the cross-linking agent was adjusted such that the molar ratio between the hydrosilyl group contained in the cross-linking agent and the vinyl group contained in the main ingredient (hydrosilyl group/vinyl group) became 0.9/1. Also, the platinum-based catalyst was added in an amount of 2 parts by mass per 100 parts by mass in total of the main ingredient and the cross-linking agent.

The prepared silicone resin composition was applied by a die-coating apparatus on the prepared support plate to a size of 345 mm in diameter (coated amount: 20 g/m²) and cured under heating in air at 210°C for 30 minutes to form and fix a silicone resin layer having a thickness of 20 µm.

On the surface of the silicone resin layer, a silicon wafer having a diameter of 340 mm and a thickness of 350 µm was pressure-contacted under a reduced pressure atmosphere to obtain a laminate consisting of a silicon wafer, a silicone resin layer and a support plate. Subsequently, the silicon wafer was fixed by adsorbing and fixing the support plate to a stage, and ground by a cup-shaped diamond wheel.

Thereafter, a sample of 50 mm square was cut out of the laminate after grinding and used as an evaluation sample. In each evaluation sample, the silicon wafer and the support plate were well adhered through the silicone resin layer therebetween.

In one evaluation sample, a razor was inserted between the silicon wafer and the silicone resin layer in a state of flatly holding the silicon wafer, thereby performing incipient separation. Subsequently, the reinforcing plate consisting of the silicone resin layer and the support plate was warped and deformed sequentially from the position at which incipient separation was performed, whereby the reinforcing plate was separated and removed from the silicon wafer. At this time, the silicone resin layer and the support plate constituting the reinforcing plate were well adhered with each other. Incidentally, the average thickness of the silicon wafer after grinding was 50 µm.

The remaining evaluation samples were placed in a nitrogen atmosphere furnace and heat-treated under the following conditions A to C.
Condition A: 150°C, 10 minutes
Condition B: 220°C, 10 minutes
Condition C: 350°C, 10 minutes
Thereafter, in each evaluation sample, the reinforcing plate consisting of the silicone resin layer and the support plate was removed from the silicon wafer in the same manner as above. At this time, the silicone resin layer and the support plate constituting the reinforcing plate were well adhered with each other. Furthermore, the presence or absence of bubbling or bulging in the silicone resin layer was confirmed, as a result, bubbling or bulging was not recognized in all of Conditions A to C. Also, a scratch or the like was not observed on the first surface of the silicon wafer.

### (Comparative Example)

In Comparative Example, a laminate was produced in the same manner as in Example except that a double-coated adhesive sheet was laminated on a hard substrate, in place of forming and fixing the silicone resin layer by applying and curing the silicone for release paper on the support plate.

The double-coated adhesive sheet used was obtained by applying the silicone resin composition of Example on both surfaces of a PET film with a thickness of 100 µm and curing. The thickness of the silicone resin layer in the double-coated adhesive sheet was adjusted to 20 µm.

From the thus-obtained laminate consisting of a silicon wafer, a double-coated adhesive sheet and a support plate, evaluation samples were produced in the same manner as in Example, and the heat resistance of the double-coated adhesive sheet was evaluated.

In Comparative Example, in the case of Condition A, a gap was observed in part between the double-coated adhesive sheet and the support plate, and a part of the PET film constituting the double-coated adhesive sheet was bulged. In the case of Condition B, the double-coated adhesive sheet and the support plate were separated, and the PET film constituting the double-coated adhesive sheet was bulged. Further, in the case of Condition C, the double-coated adhesive sheet and the support plate were separated, and the PET film constituting the double-coated adhesive sheet was thermally decomposed and shrunk.

Incidentally, a transistor, wiring, an electrode and the like are not produced on the first surface and the second surface of the wafer used in these Example and Comparative Example, but they are very small compared with the wafer and their presence or absence is considered to scarcely affect the evaluation results above.

While the present invention has been described in detail and with reference to the embodiments thereof, it will be apparent to one skilled in the art that various changes and modifications can be made therein without departing from the spirit and scope thereof.
The present application is based on Japanese Patent Application No. 2010-206900 filed on September 15, 2010, and the entire contents thereof are incorporated herein by reference. All references cited herein are incorporated in their entirety.

## Claims

1. A method for manufacturing a semiconductor device, comprising:
a first step of producing a first component part of a semiconductor device on a first surface of a semiconductor wafer;
a second step of laminating a support plate to the first surface of said semiconductor wafer, on which the first component part has been produced, through only a silicone resin layer therebetween;
a third step of grinding a second surface opposing said first surface of said semiconductor wafer, in the state of the support plate being laminated, and then producing a second component part of said semiconductor device on the ground surface; and
a fourth step of peeling off said silicone resin layer from said semiconductor wafer on which said first component part and said second component part have been produced, thereby removing said silicone resin layer and said support plate, and cutting said semiconductor wafer into a chip.

2. The method for manufacturing a semiconductor device according to claim 1,
wherein said second component part contains a penetrating electrode penetrating from said ground surface to said first surface of said semiconductor wafer.

3. The method for manufacturing a semiconductor device according to claim 1 or 2,
wherein said silicone resin layer is formed of a cured product of a silicone for release paper.

4. The method for manufacturing a semiconductor device according to claim 3,
wherein said cured product of a silicone for release paper is a cross-linking-reaction product of a linear polyorganosiloxane having a vinyl group at both terminals and/or in the side chain and a methylhydrogenpolysiloxane having a hydrosilyl group within the molecule.

5. The method for manufacturing a semiconductor device according to claim 4,
wherein the molar ratio (hydrosilyl group/vinyl group) between said hydrosilyl group contained in said methylhydrogenpolysiloxane and the vinyl group contained in said linear polyorganosiloxane is from 1.3/1 to 0.7/1.

6. The method for manufacturing a semiconductor device according to any one of claims 1 to 5,
wherein the absolute value of the difference in the average linear expansion coefficient between said support plate and said semiconductor wafer is 35×10⁻⁷/°C or less.

7. The method for manufacturing a semiconductor device according to any one of claims 1 to 6,
wherein in said second step, said support plate is pressure-contacted with said first surface of said semiconductor wafer, on which said first component part has been produced, through said silicone resin layer therebetween under a reduced pressure atmosphere.

8. The method for manufacturing a semiconductor device according to any one of claims 1 to 7,
wherein in said second step, after fixing said silicone resin layer to said support plate, said silicone resin layer is laminated to said first surface of said semiconductor wafer, on which said first component part has been produced.

9. The method for manufacturing a semiconductor device according to claim 8,
wherein said silicone resin layer is formed and fixed by coating and curing a silicone for release paper on said support plate.

10. The method for manufacturing a semiconductor device according to claim 9,
wherein the content of a nonreactive silicone in said silicone for release paper is 5 mass% or less.

11. The method for manufacturing a semiconductor device according to claim 9 or 10,
wherein said silicone for release paper is coated by using a die-coating method, a spin-coating method or a screen-printing method.

12. The method for manufacturing a semiconductor device according to any one of claims 9 to 11,
wherein said silicone for release paper is cured at a temperature of 50 to 250°C.
